# EUROPEAN PATENT APPLICATION

(11) **EP 0 614 226 A1**
(43) Date of publication of application: **07.09.1994**
(21) Application number: 93116059.2
(22) Date of filing: 05.10.1993
(51) Int. Cl.: H01L 29/62

(54) **Gate electrode using stacked layers of TiN and polysilicon**

(30) Priority: 05.10.1992 US 956141
(71) Applicant: TEXAS INSTRUMENTS INCORPORATED, Dallas Texas 75265 (US)
(72) Inventor: Hwang,Jeong-Mo, Plano TX 75023 (US); Pollack,Gordon, Richardson TX 75080 (US)
(74) Representative: Schwepfinger, Karl-Heinz, Dipl.-Ing.

(57) **Abstract**

Mid bandgap work function materials (TiN) sandwiched between the gate oxide (2) and poly Si portion of MOSFET gate are disclosed as solving threshold voltage accuracy and symmetry problems for CMOS technology.

## Description

### BACKGROUND OF THE INVENTION

In fully-depleted Silicon-on-Insulator Complementary Metal Oxide Silicon Field Effect Transistors (SOI/MOSFETs) it is vary difficult to achieve symmetric threshold voltages far the n-channel and p-channel transistors with the conventional polysilicon gate. Restated, in order to ensure proper CMOS operation, it is desirable for the threshold voltages of the n-channel and p-channel devices to have the same absolute value. Such is difficult to achieve with conventional polysilicon gates. Further, it is difficult to achieve proper threshold voltages suitable for both n and p channel devices.

### SUMMARY OF THE INVENTION

The invention provides proper and symmetric threshold voltages suitable for CMOS logic applications, for n-channel and p-channel MOSFETs through the use of a gate electrode structure in which a thin TiN layer is sandwiched in between the gate oxide of the MOSFET and the polysilicon gate portion of the MOSFET.

### BRIEF DESCRIPTION OF THE DRAWINGS

Figure 1 illustrates a cross-sectional view of a first preferred embodiment of the invention.

Figure 2 illustrates a cross-sectional drawing of a second preferred embodiment of the invention.

Figure 3 illustrates a schematic drawing of p and n type MOSFET SOI devices having a common gate connector.

Figure 4 illustrates a cross-sectional view of a third preferred embodiment of the invention using a poly Si-Ge material in place of TiN.

### DETAILED DESCRIPTION OF THE INVENTION

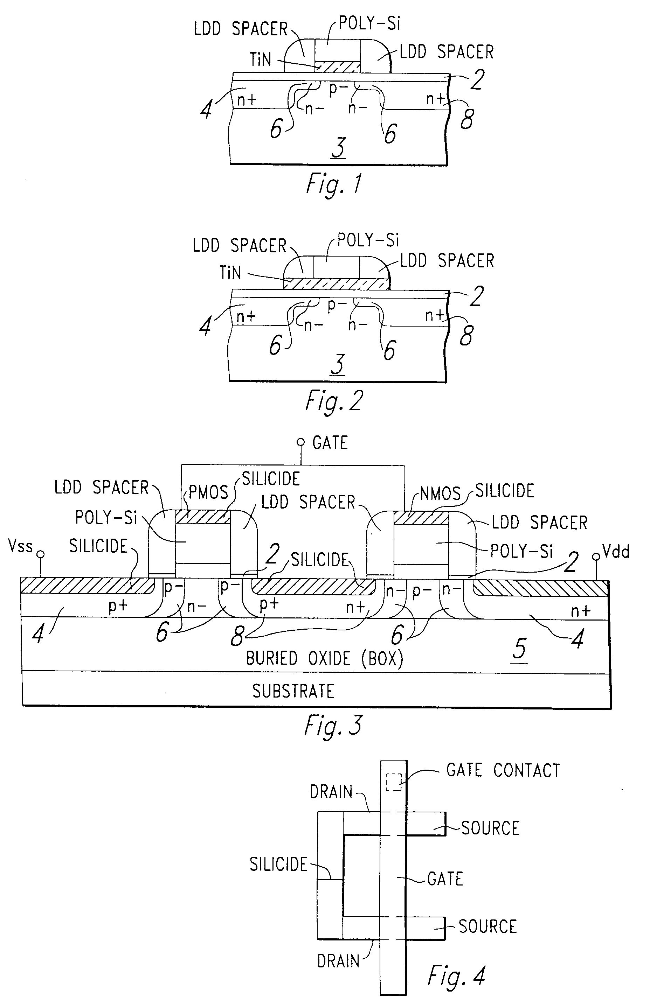

Figure 1 illustrates a cross-sectional view of a first preferred embodiment of the invention. As shown, a titanium nitride, TiN, is sandwiched in between a polysilicon gate portion (Poly-Si) and gate oxide 2 overlying lightly doped p-type (p-) silicon film 3 which overlies insulator 5. Source region 4 is shown as a highly doped n-type material (n+). Likewise, drain region 8 is shown as a highly doped n-type material (n+). Lightly doped drain regions (LDD) 6 extend from both the source and drain regions and are shown as lightly doped n-type material (n-). LDD spacers abut the poly silicon gate portion. The process for forming the structure of figure 1 is as follows:
1) Grow an oxide layer over silicon film 3.
2) Deposit TiN over the oxide layer (optimally less than 1000 Å) either by chemical vapor deposition or by plasma sputtering.
3) Deposit a polysilicon layer over said gate oxide (optimally approximately 3500 to 4500 Å).
4) Etch the polysilicon so as to form the gate portion shown (optimally by conventional dry etch).
5) Etch the TiN using the polysilicon gate portion as a mask (optimally by conventional dry etch) to form a TiN portion of the device gate.
6) Perform a LDD implant,
7. Form LDD spacers (optimally using CVD oxide)
8. Perform source and drain implants.

Figure 2 illustrates a cross-sectional drawing of a second preferred embodiment of the invention. Figure 2 shows an Inverse -T-gate. This structure is formed similarly to the structure of figure 1 with the following exceptions:
After step 5 above,
6) Perform the LDD implant.
7) Form the LDD spacers.
8) Etch the TiN.
9) Cover the TiN edges with CVD oxide (similar to the LDD spacer process forming the structure of figure 1 to get the structure of figure 2).

For further illustration of a CMOS circuit using the invention, figure 3 illustrates a schematic drawing of the p and n type MOSFET SOI devices having a common gate connector 12 making contact with the poly-Si gates through via 14 using metal layer 16.

The advantages of the invention include the following:
a) Since TiN has the same work function as intrinsic poly-Si (work function = 4.7 volts) it is easy to obtain a balanced threshold voltage for CMOS circuits (both n-channel and p-channel) without using a buried p-channel. This is particularly important for fully-depleted SOI/CMOS. In SOI/MOSFET (fully-depleted SOI) it is extremely difficult to obtain proper threshold voltages and symmetric threshold voltages for n-channel and p-channel devices with conventional poly-gate. N+ poly-gate gives too low a threshold voltage for n-channel devices but too high a threshold voltage for p-channel devices and vice versa for p+ poly gates. TiN formed gates of the invention will be able to provide proper and symmetric threshold voltages for CMOS circuits.
b) The relatively thick polysilicon gate portion provides the advantages associated with the convention polysilicon process such as self-aligned source/drain implant and self-aligned silicide.
c) The inverse T-gate structure has additional advantages as in with the conventional polysilicon inverse T-gate. It ensures the gate overlap across the source and drain junction. More importantly, the structure for the inverse T-gate improves the drive current degradation due to charging up in the spacer oxide by hot-carrier injection or high-energy photon irradiation.

TiN's suitability for solving the aforementioned threshold voltage problems is due to its mid-gap work function. A mid bandgap work function is generally defined to be in the range of approximately 4.6 to 4.8 volts. Although the invention has been shown and described as using TiN as part of the gate, other materials possessing a mid-gap work function can be used in place of TiN. Mid-gap work function material sandwiched in between the gate oxide and the poly-Si gate portion simplifies the structure as well as minimizes the gate oxide stress. Suitable mid-gap work function materials include Si-Ge and tungsten silicide. For example, figure 4 illustrates a cross-sectional view of a third preferred embodiment of the invention using a poly Si-Ge material in place of TiN. Silicided regions are shown as indicated. A field oxide region formed by the well known LOCOS process provides field isolation and is indicated as LOCOS FOX. Buried oxide (BOX) region 5 is formed over a substrate. The PMOS and NMOS devices are indicated as shown.

Although the invention has been described in detail herein with reference to its preferred embodiment and certain described alternatives, it is to be understood that this description is by way of example only, and is not to be construed in a limiting sense. For instance, p-channel devices can be substituted for n-channel devices and vice versa. Further, n-type regions can be substituted for p-type regions. Additionally, Ge and GaAs can be substituted for the thin film upon which the devices lie while in keeping with the spirit of using mid bandgap work functions. It is to be further understood that numerous changes in the details of the embodiments of the invention, and additional embodiments of the invention will be apparent to, and may be made by persons of ordinary skill in the art having reference to this description. It is contemplated that all such changes and additional embodiments are within the spirit and true scope of the invention as claimed below.

## Claims

1. A MOSFET comprising a gate including a mid bandgap semiconductor material and a gate portion including silicon, said mid bandgap material being sandwiched between a gate oxide and said gate portion.

2. A MOSFET as recited in claim 1 wherein said mid bandgap material is selected from the group consisting of TiN, Si-Ge, titanium silicide or a combination thereof.

3. A MOSFET as recited in claim 1 wherein said gate portion including silicon comprises polycrystalline silicon.

4. A CMOS device including a NMOS transistor and a PMOS transistor, each transistor comprising a gate including a mid bandgap material and a gate portion including silicon, said mid bandgap material being sandwiched between a gate oxide and said gate portion.

5. A CMOS device as recited in claim 4 wherein said mid bandgap material is selected from the group consisting of TiN, Si-Ge, titanium silicide or a combination thereof.

6. A CMOS device as recited in claim 4 wherein said gate portion including silicon comprises polycrystalline silicon.
